(19) Europäisches Patentamt
European Patent Office
Office européen des brevets

(11) EP 0 434 315 B1

(12) EUROPEAN PATENT SPECIFICATION

(45) Date of publication and mention of the grant of the patent:
**21.02.1996 Bulletin 1996/08**

(51) Int Cl.6: **G11B 20/18**

(21) Application number: **90313658.8**

(22) Date of filing: **14.12.1990**

# (54) Error correction in data storage devices

Fehlerkorrektur in Datenspeichervorrichtungen

Correction des erreurs dans des dispositifs de mémorisation des données

(84) Designated Contracting States:
**DE FR GB**

(30) Priority: **21.12.1989 US 455197**

(43) Date of publication of application:
**26.06.1991 Bulletin 1991/26**

(73) Proprietor: **International Business Machines Corporation**
**Armonk, N.Y. 10504 (US)**

(72) Inventors:
- **Blaum, Miguel Mario**
**San Jose, CA 95119 (US)**
- **Hao, Hsieh Tung**
**Los Altos CA 94022 (US)**

(74) Representative: **Burt, Roger James, Dr.**
**Winchester, Hampshire SO21 2JN (GB)**

(56) References cited:
**EP-A- 0 299 818**
**DE-A- 3 630 375**
**US-A- 4 328 580**
**US-A- 4 833 679**
**US-A- 4 847 705**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 434 315 B1

## Description

This invention relates to the correction of errors in data storage devices such as magnetic or optical disks.

Detection and correction of errors in data stored in magnetic or optical disks is typically performed using so-called Reed-Solomon (RS) codes, which generate redundant bytes from which error syndromes can be calculated. When the redundancy of a RS code is 2t bytes, the code can correct up to s bytes in error and e erased bytes, where $2s+e \leq 2t$. It will be assumed that a byte consists of 8 bits; hence RS codes consisting of elements of the Galois field GF(256) will be considered.

Normally, the data is stored in sectors, each containing 512 user bytes. Since noise in the channel affects recovery of these user bytes, redundancy is added to them using a RS code and by dividing each sector into eight strings of 64 information bytes by encoding each string and interleaving the eight strings protection is obtained against bursts of noise.

The parameter t is an indicator of the error-correcting capability t of the RS code. The choice of t is determined by the statistics of errors in the magnetic or optical recording channel. In general, t is chosen in such a way that it provides adequate protection against a worst case of errors in normal operating conditions.

New techniques for magnetic and optical recording involve recording in multiple bands; i.e., an inner band (1), a second band (2) and so on, until reaching the outermost band (m). Usually in multiband recording, the clock frequency of each band is designed to be directly proportional to the inner diameter (ID) of that band. As a result, higher error rates will occur on the outer bands than on the inner bands since the signal detection window is narrower and the head flying height is higher on the outer bands.

Conventionally systems employing such techniques use a RS code whose error correcting capability t is adequate to handle the error rates in the outer band. However, such a procedure is wasteful. Since the inner bands suffer less errors, they do not require so much redundancy. One approach to this problem is to implement different RLL codes according to the band being accessed, as described in U.S. patent 4,804,959 proposing e.g. the (1,7) and (2,7) run-length-limited codes. This prior art is acknowledged in claims 1 and 8. While this is feasible, it complicates the hardware significantly, since a multiplicity of decoders and attendant selection circuitry are required.

Another approach to the problem of excess correction power is described in the paper entitled "Error Control Techniques Applicable to HF Channels", published in the IEE Proceedings, Vol. 136, Pt. 1, No. 1, February 1989 at pp. 57-63. This paper describes a technique that involves puncturing, that is deleting certain symbols, in RS codes for a high frequency (HF) channel. Here a product code is used adaptively as follows: each row and column is decoded independently. However, instead of transmitting the full row (or column), a punctured codeword is transmitted from which f symbols have been deleted. The deleted symbols are treated as erasures and assumed to be zero by the receiver, which calculates the modified syndromes. If these modified syndromes are zero, the receiver concludes that no errors have occurred. If some syndromes are not zero, then the sender sends the additional (previously deleted) redundant bytes and correction is attempted. This technique achieves an improvement in throughput in a HF channel by reducing the average redundancy required for detection of errors. However when correction is necessary the additional redundancy is required.

Such an approach is not readily applicable to data storage apparatus employing media such as magnetic or optical disks wherein the inner storage bands require consistently different error correction capability than the outer bands, and the provision of excess correcting power for those bands exhibiting lower error rates would still be wasteful. Moreover, in such apparatus writing and reading of data conventionally involve only one-way communication, and the provision of facilities for requesting retransmission when errors are detected, rather than applying the appropriate correction power, would incur considerable cost.

According to the invention there is provided, a method of error correction for use with a disk storage medium whose statistics of error vary according to the location where data is recorded, comprising the steps of encoding the data in accordance with an error correcting code capable of correcting a given number of errors to develop words including data bytes and redundant bytes, and dividing said storage disk into concentric recording bands whose data are differently coded, the method being characterised in that different statistics of error are applied, to different recording bands, in that one or more of said redundant bytes are suppressed from the encoded data according to the recording band to be accessed, thereby adjusting the number of correctable errors in accordance with the need for error correction capability in each recording area, and in that: the number of redundant bytes suppressed is determined by the radius of the band to be accessed.

There is also provided a data storage device including a disk storage medium, divided into concentric recording bands whose data are differently coded, an encoder adapted to encode data for recording in accordance with an error correcting code capable of correcting a given number of errors to develop words including data bytes and redundant bytes, characterised in that it is adapted to apply different statistics of error to different recording bands and in that it further includes an area identifier, adapted to produce an output identifying the recording band in which data is to be recorded, and a deleter responsive to the output of said area identifier to suppress selected ones of said redundant bytes.

In a preferred embodiment of the invention, for disks recorded in multiple concentric bands, a RS code is selected having data bytes and redundant bytes and an error-correcting capability sufficient to protect against an anticipated

worst case of errors on the disk. The data bytes and redundant bytes are recorded at each band at a clock frequency proportional to the inner diameter of that respective band. The number of redundant bytes in the code is progressively reduced at each successive band toward the innermost band, thereby progressively reducing the number of correctable errors as error rate reduces toward the centre of the disk. This permits the use of decoders that have a complexity no greater than that of traditional RS decoders yet provide more error correction in the outer bands and allow significant savings in redundancy in the inner bands.

## Brief Description of the Drawings

Fig. 1 is a schematic diagram showing the encoding process for implementing the invention; and

Fig. 2 is a schematic diagram showing the decoding process for implementing the invention.

## Description of Preferred Embodiment

### I. Introduction and Theory

Assume initially that a multiband disk has bands denoted 1,2,...,m, starting with innermost band 1. In band 1 we implement a t error-correcting RS code; and in band 2, a t+1 error-correcting code, etc., such that in band m, a t+m-1 error-correcting code is implemented. However, the encoding and decoding circuits of the t+m-1 error-correcting code are used. This is done by exploiting the nested structure of RS codes.

Assuming a conventional disk drive wherein the error-correcting capability of RS codes does not exceed 8 bytes, it is necessary that $1 \le t$ and $t+m-1 \le 8$. Assuming now $\alpha$ to be a primitive element in GF(256), then $\alpha$ is a root of the primitive polynomial $p(x)=1+x^2+x^3+x^4+x^8$. Let $g(x)=\pi_{l=1}^{2(t+m-1)}(x+\alpha^l)$. To encode an information polynomial $a(x)=a_0+a_1x+...+a_{k-1}x^{k-1}$ in band i, $1 \le i \le m$. The encoder proceeds as follows:

1. Determine

$$b(x)=\Sigma_{l=0}^{2(t+m-1)-1} b_l x^l$$

as the result of dividing $x^{2(t+m+1)}a(x)$ by g(x).

2. Let

$$b^{(i)}(x)=(\Sigma_{l=2(m-i)}^{2(t+m-1)-1} b_l x^l)/x^{2(m-i)}.$$

Encode a(x) as $b^{(i)}(x)+x^{2(t+i-1)}a(x)$.

Note that the encoder uses the same circuits as the encoder of a RS code with generator polynomial g(x). This is the code which would be used with the traditional error correcting approach. Each codeword is divided into two parts: first the redundancy, represented by the polynomial $b^{(i)}(x)$, and then the information part, represented by the polynomial $x^{2(t+i-1)}a(x)$. The redundancy thus depends on the band being accessed: in band i, the codewords carry 2(t+i-1) redundant bytes.

To decode, assuming that band i is being accessed and the received polynomial is

$$r(x)=\Sigma_{l=0}^{k+2(t+i-1)} r_l x^l,$$

proceed as follows:

1. Use the polynomial $r^{(i)}(x)=x^{2(m-i)}r(x)$.

2. Apply an error-erasure decoding algorithm to $r^{(i)}(x)$, assuming erasures in bytes 0,1,...,2(m-i)-1.

3. Produce as output the estimate $\hat{a}(x)$ of the information polynomial a(x).

Thus, the decoder also uses the decoding algorithm of the RS code generated by g(x).

## II. Detailed Description

### A.1 - Encoding Process - Fig. 1

The input for the encoding process is a string of information bytes

$$a_0,a_1,\ldots,a_{k-1} \quad (A)$$

This string is sent to a [k+2(t+m-1),k] RS-encoder 10. Encoder 10 performs the operation described in Section I and produces as output the redundant bytes

$$b_0,b_1,\ldots,b_{2(t+m-1)-1} \quad (B)$$

The redundant bytes are transmitted to a deleter 11, which also receives as input from a track identifier 12 the track number i in which the data, 1≤i≤m, is to be encoded. Deleter 11 discards the first 2(m-i) redundant bytes and produces as output the string

$$b_{2(m-i)},b_{2(m-i)+1},\ldots,b_{2(t+m-1)-1} \quad (C)$$

Finally, the input data string A is merged at 13 with deleter output string C to provide, as the encoder output the string

$$b_{2(m-i)},b_{2(m-i)+1},\ldots,b_{2(t+m-1)-1},a_0,a_1,\ldots,a_k \quad (D)$$

### A.2 - Example Using Encoding Process

For sake of illustration, assume that m, the number of bands =4, that t, the error-correcting capability of the code in the innermost band 1 =3; and that k, the number of information bytes in each codeword =64 (i.e., there are 4 codewords per sector).

These assumptions imply that a 6-byte correcting RS code must be implemented. So, the generator polynomial, g (x), is $g(x)=\pi_{l=1}^{12}(x+\alpha^1)$. The full power of the code, however, is used only in the outermost band 4.

The number of information bytes, k, is fixed and has above been assumed to be 64. The number of redundant bytes, however, depends on the band. Let

$$a(x)=\Sigma_{l=0}^{63}a_l x^l$$

be an information string to be encoded.

Assume now a circuit that divides by g(x) and find the result of the division. Circuits of this type are straightforward in implementation of RS codes. Now let

$$b(x)=\Sigma_{l=0}^{11}b_l x^l$$

be the result of dividing $x^{12}a(x)$ by g(x). The output of the encoder in polynomial notation then is, according to the band in which we want to encode a(x): For band 1:

$$b_6+b_7x+\ldots+b_{11}x^5+a_0x^6+a_1x^7+\ldots+a_{63}x^{69}$$

For band 2:

$$b_4+b_5x+\ldots+b_{11}x^7+a_0x^8+a_1x^9+\ldots+a_{63}x^{71}$$

For band 3:

$$b_2+b_3x+\ldots+b_{11}x^9+a_0x^{10}+a_1x^{11}+\ldots+a_{63}x^{73}$$

For band 4:

$$b_0+b_1x+\ldots+b_{11}x^{11}+a_0x^{12}+a_1x^{13}+\ldots+a_{63}x^{75}$$

If the channel is bursty, encoding can be completed by interleaving the eight codewords corresponding to each sector in the manner described at pp. 271-272 in Error Control Coding: Fundamentals and Applications, by Lin and Costello, published in 1983 by Prentice-Hall. This allows the code to correct several bursts of length up to 57 bits each.

**B.1 - Decoding Process - Fig. 2**

If the code has been interleaved, the first step is to deinterleave.

The length of the received word depends upon the band being considered. In band i, $1 \le i \le m$, the received word has length k+2(t+i-1). So, assume that band i is being accessed and let

$$r_0, r_1, \dots, r_{k+2(t+i-1)-1} \quad (E)$$

be the input for the decoding process. It is desired that the same decoding circuits be used as the regular [k+2(t+m-1),k] code, so the first step in decoding using a 0 adder 20 adding 0's at the beginning of the received word in such a way that a vector of length k+2(t+m-1) is obtained which in polynomial notation is expressed as

$$r^{(i)}(x)=x^{2(m-i)} \sum_{l=0}^{k+2(t+i-1)-1} r_l x^l, \quad (F)$$

as in Section I. Polynomial (F) is transmitted to a syndromes generator 21, where the 2(t+m-1) syndromes are estimated. Specifically,

$$S_j=r^{(i)}(\alpha^j)=\alpha^{2(m-1)j} \sum_{l=0}^{k+2(t+i-1)-1} r_l \alpha^{jl}, 1 \le j \le 2(t+m-1),$$

which expressed as a syndrome polynomial is

$$S(x)=S_1+S_2x+\dots+S_{2(t+m-1)}x^{2(t+m-1)-1} \quad (G)$$

Now, the first 2(m-i) locations are considered as erasures. So, it is necessary to calculate the erasure locator polynomial

$${}_i(x)=(x+\alpha^0)(x+\alpha)\dots(x+\alpha^{2(m-i)-1}). \quad (H)$$

Since it is known a priori what the erasures are, the polynomials ${}_i(x), 1 \le i \le m$ will meanwhile have been stored in a polynomial selector 22 that receives as input the band i from a track identifier 23 and produces as output the (H) polynomial

${}_i(x)$ (Convention: ${}_m(x)=1$). The outputs (G) and (H) of the syndromes generator 21 and polynomial selector 22 are input to a modified syndromes generator 24 that produces as output the product

$$S(x)\ {}_i(x). \quad (I)$$

The modified syndrome polynomial (I) is fed to a RS-decoder 25. RS-decoder 25 solves the fundamental equation

$$(x)\ {}_i(x)S(x) \equiv _(x)(\mathrm{mod}\, x^{2(t+m-1)}),$$

where (x), the error locator polynomial, is a polynomial of degree$\le$t+i-1 and _(x), the error evaluator polynomial, has degree$\le$t+2m-i-2. Decoder 25 finds

(x) and _(x) using variations of Euclid's algorithm. Circuits that implement this algorithm are well-known; for example, see Practical Error Correction Design for Engineers, by Glover and Dudley, Data Systems Technology, 1988 at pp. 163-167. The roots of (x) give the locations of the errors. If an error location, say j, is known, the value of the error at that location, say e., is obtained by performing the operation

$$e_j=\frac{(\alpha^j)}{'(\alpha^j)\ {}_i(\alpha^j)+(\alpha^j)\ {}'_i(\alpha^j)}$$

The output of the RS-decoder is the string

$$e_{2(t+i-1)}, e_{2(t+i-1)+1}, \dots, e_{k+2(t+i-1)-1} \quad (J)$$

which includes only the errors corresponding to the information bytes. (Note that there is no interest in errors in the redundant bytes).

Decoder output (J) is transmitted to an estimator of information bytes 26. Meanwhile, the original input (E) is sent

to a separator 27 that produces as output the received bytes

$$r_{2(t+i-1)}, r_{2(t+i-1)+1}, \ldots, r_{k+2(t+i-1)-1} \quad \text{(K)}$$

corresponding to the information locations. This output (K) is also transmitted to the estimator of information bytes 26, which simply performs the operation

$$\hat{a}_j = r_j + e_j, 2(t+i-1) \leq j \leq k+2(t+i-1)-1$$

So, the final output from the decoding process is the estimation

$$\hat{a}_{2(t+i-1)}, \hat{a}_{2(t+i-1)+1}, \ldots, \hat{a}_{k+2(t+i-1)-1} \quad \text{(L)}$$

of the string of k information bytes.

### B.2 - Example Using Decoding Process

As earlier noted, if the code has been interleaved, the first step is to deinterleave. Also, as will be apparent from the foregoing description, the length of each encoded polynomial depends on the band being accessed. The first step in decoding is making the received polynomial have a length 76 by adding an appropriate number of 0's at the beginning. Assume that there is an error-erasure decoder, like 25, for a [76,64] RS code, and then proceed as follows:

For band 1: Let $r(x)=r_0+r_1x+\ldots+r_{69}x^{69}$ be the received polynomial. Apply the decoding algorithm with respect to $x^6r(x)$ by adding 6 0's at the beginning, as a result of assuming that the first 6 bytes are erasures.

For band 2: Let $r(x)=r_0+r_1x+\ldots+r_{71}x^{71}$ be the received polynomial. Apply the decoding algorithm with respect to $x^4r(x)$ by adding 4 0's at the beginning, as a result of assuming that the first 4 bytes are erasures.

For band 3: Let $r(x)=r_0+r_1x+\ldots+r_{73}x^{73}$ be the received polynomial. Apply the decoding algorithm with respect to $r(x)$. No 0's will be added so that full error correcting capability will be available.

In all cases, the decoder produces as output the estimate

$$\hat{a}(x)=\hat{a}_0+\hat{a}_1x+\ldots+\hat{a}_{63}x^{63}$$

of the information polynomial

$$a(x)=a_0+a_1x+\ldots+a_{63}x^{63}.$$

The [76,64] RS codes can correct s errors and e erasures whenever $2s+e \leq 12$. It will therefore be apparent that in band 1, with 6 erasures, the code can correct 3 bytes in error; in band 2, with 4 erasures, the code can correct 4 bytes in error; in band 3, with 2 erasures, it can correct 5 bytes in error; and in band 4, with no erasures, it can correct 6 bytes in error.

### III. Summary

It will thus be seen that a novel method has been described for implementing error-correcting codes for multiband disks wherein the code is adapted to the error statistics of each band. The code is e.g. adapted to use less redundancy in the inner bands, where less noise occurs, thereby providing an overall gain in redundancy with respect to the traditional method. Applicants' method uses a RS encoder and decoder with the same circuits and the same degree of complexity as required for the traditional method. However, by truncating a certain number of bytes at the beginning of a codeword, redundancy is saved and adapted to the error-correcting necessities of the band. The decoder considers those truncated bytes as erasures.

Applicants' method allows significant savings in redundancy without compromising error-correcting capability. For example, in the four-band disk configuration assumed for purposes of the above description, if all the bands have the same number of sectors, on average, 9 redundant bytes are used per codeword (i.e., 36 redundant bytes per sector). By contrast, the traditional method would use 12 redundant bytes per codeword (i.e., 48 redundant bytes per sector). Applicants' method thus provides an increase in storage capacity for the disk of about 5%.

### IV. Other Applications of the Invention

While the invention has been illustrated as applied to multiband disks wherein error rates are highest in the outermost band, it can also be applied to conventional magnetic disks, wherein error rates are highest in the innermost band. In the latter case, the number of redundant bytes will be progressively increased (rather than reduced) at each successive band toward the innermost band where magnetic transitions are more closely spaced.

Applicants' method can also be applied to read-write optical drives using multiband recording. One problem with

optical storage is corrosion, with the result that the error statistics of the bands vary as a function of time. If these error statistics of the bands as a function of time are known, the error-correcting capability of the code can be enhanced at regular periods. Of course, storage capacity will be somewhat limited after doing so, but the lifetime of the storage disk will be considerably extended. If the effects of corrosion in time are not known, the behaviour of the media can be monitored by counting the number of errors; and if the number of errors exceeds a certain threshold, the code can be modified to insert a fewer number of 0's in the inner bands. This modification to insert fewer 0's can be accomplished adaptively by automatic feedback from the error counter to the modified syndromes generator 24. Thus by dynamically sensing errors in the respective bands, the redundancy of the error-correcting code can be adaptively modified to assure appropriate error correcting capability.

## Claims

1. A method of error correction for use with a disk storage medium whose statistics of error vary according to the location where data is recorded, comprising the steps of encoding the data in accordance with an error correcting code capable of correcting a given number of errors to develop words including data bytes and redundant bytes and dividing said storage disk into concentric recording bands whose data are differently coded, the method being characterised in that different statistics of error are applied, to different recording bands, in that one or more of said redundant bytes are suppressed from the encoded data according to the recording band to be accessed, thereby adjusting the number of correctable errors in accordance with the need for error correction capability in each recording area, and in that the number of redundant bytes suppressed is determined by the radii of the band to be accessed.

2. A method as claimed in claim 1, in which data is recorded in each band at a clock frequency increasing with the inner radius of the band, and in which the number of redundant bytes suppressed is reduced progressively for bands of higher radius.

3. A method as claimed in claim 1, in which data is recorded at a fixed frequency and the number of redundant bytes suppressed is reduced progressively for bands of lower radius.

4. A method as claimed in any preceding claim in which said error correcting code is a Reed - Solomon code having an error correction capability selected to protect the data against an anticipated worst case incidence of errors in data recorded on said medium.

5. A method as claimed in claim 4, further including the step, when reading data from said medium, of augmenting each word read with a number of zero bytes sufficient to compensate for the redundant bytes suppressed at the time of recording and treating each zero byte as an erasure for the purpose of decoding.

6. A method as claimed in any preceding claim for use with a storage medium whose statistics of error vary with time, including the step of determining the error statistics of said medium from time to time and changing the number of redundant bytes suppressed in accordance with any changes in such statistics.

7. A method as claimed in claim 6 in which said error statistics are determined by monitoring the incidence of errors in data read from said medium.

8. A data storage device including a disk storage medium, divided into concentric recording bands whose data are differently coded, an encoder (10) adapted to encode data for recording in accordance with an error correcting code capable of correcting a given number of errors to develop words including data bytes and redundant bytes, characterised in that it is adapted to apply different statistics of error to different recording bands and in that it further includes an area identifier (12), adapted to produce an output identifying the recording band in which data is to be recorded, and a deleter (11) responsive to the output of said area identifier to suppress selected ones of said redundant bytes.

9. A device as claimed in claim 8 in which said error correcting code is a Reed - Solomon code having an error correction capability selected to protect the data against an anticipated worst case incidence or errors in data recorded in said medium, further characterised by a zero adder (20) responsive to words read from said medium to augment such words with a number of added zero bytes sufficient to compensate for the number of redundant bytes suppressed from the recorded data word, a syndrome generator (21), (22), (24) operable to develop from a word so augmented an error syndrome polynomial (I) appropriate to the area from which the word was read, and a decoder (25) adapted

to decode data encoded in accordance with said Reed - Solomon code and to treat added zero bytes as erasures.

10. A device as claimed in claims 8 or 9 including an error counter arranged to monitor the incidence of errors in data read from said medium, further characterised by feedback means arranged to control the number of redundant bytes suppressed according to the setting of said error counter.

**Patentansprüche**

1. Ein Verfahren zur Fehlerkorrektur für ein Plattenspeichermedium, dessen Fehlerstatistik je nach Speicherplatz der aufgezeichneten Daten variiert, und bei dem die Daten in Übereinstimmung mit einem Fehlerkorrekturcode, der eine gegebene Anzahl von Fehlern korrigieren kann, codiert werden, um Wörter einschließlich Datenbytes und redundante Bytes zu erzeugen, und bei dem die Speicherplatte in konzentrische Aufzeichnungsbänder unterteilt wird, deren Daten unterschiedlich codiert sind, wobei das Verfahren dadurch gekennzeichnet ist, daß unterschiedliche Fehlerstatistiken für unterschiedliche Aufzeichnungsbänder angewendet werden, so daß eines oder mehrere der redundanten Bytes aus den codierten Daten je nach Aufzeichnungsband, auf das zugegriffen wird, gelöscht wird, wodurch die Zahl der korrigierbaren Fehler in Übereinstimmung mit den Anforderungen nach Fehlerkorrekturfähigkeit in jedem Aufzeichnungsbereich angepaßt wird, und so daß die Zahl der gelöschten redundanten Bytes vom Radius des Bandes bestimmt wird, auf das zugegriffen wird.

2. Ein Verfahren nach Anspruch 1, bei dem Daten in jedem Band mit einer Taktfrequenz aufgezeichnet werden, die mit dem Innenradius des Bandes zunimmt, und bei dem die Zahl der unterdrückten redundanten Bytes für Bänder mit größerem Radius schrittweise reduziert wird.

3. Ein Verfahren nach Anspruch 1, bei dem die Daten mit einer festen Frequenz aufgezeichnet werden und die Zahl der unterdrückten redundanten Bytes für Bänder mit niedrigerem Radius schrittweise reduziert wird.

4. Ein Verfahren nach einem der oben genannten Ansprüche, bei dem der Fehlerkorrekturcode ein Reed-Solomon-Code mit einer ausgewählten Fehlerkorrekturfähigkeit ist, die die Daten gegen den schlimmstmöglich angenommenen Fall von auftretenden Fehlern in den auf dem Medium aufgezeichneten Daten schützt.

5. Ein Verfahren nach Anspruch 4, das weiterhin den Schritt umfaßt, jedes gelesene Wort beim Lesen von Daten mit einer Zahl von Nullbytes zu erhöhen, die ausreicht, um für die unterdrückten redundanten Bytes während der Aufzeichnung einen Ausgleich zu schaffen, wobei jedes Nullbyte zum Zweck der Decodierung als eine Löschung angesehen wird.

6. Ein Verfahren nach einem der oben genannten Ansprüche für ein Speichermedium, dessen Fehlerstatistik zeitabhängig variiert, und das den Schritt beinhaltet, die Fehlerstatistiken des Mediums von Zeit zu Zeit zu bestimmen und die Anzahl der unterdrückten redundanten Bytes in Übereinstimmung mit Änderungen in der Statistik zu ändern.

7. Ein Verfahren nach Anspruch 6, bei dem die Fehlerstatistiken dadurch bestimmt werden, daß das Auftreten von Fehlern in vom Medium gelesenen Daten überwacht wird.

8. Eine Datenspeichervorrichtung mit einem Plattenspeichermedium, das in konzentrische Aufzeichnungsbänder unterteilt ist, deren Daten unterschiedlich codiert sind, einem Codierer (10), der die Daten zur Aufzeichnung in Übereinstimmung mit einem Fehlerkorrekturcode codiert, der eine gegebene Anzahl von Fehlern korrigieren kann, um Wörter einschließlich Datenbytes und redundante Bytes zu erzeugen, wobei das System dadurch gekennzeichnet ist, daß unterschiedliche Fehlerstatistiken bei unterschiedlichen Aufzeichnungsbändern angewendet werden, und daß weiterhin ein Bereichsbezeichner (12) vorhanden ist, der eine Ausgabe erzeugt, welche das Aufzeichnungsband identifiziert, in dem die Daten aufgezeichnet werden, sowie eine Löschvorrichtung (11), die auf die Ausgabe des Bereichsbezeichners reagiert, um ausgewählte redundante Bytes zu löschen.

9. Eine Vorrichtung nach Anspruch 8, bei der der Fehlerkorrekturcode ein Reed-Solomon-Code mit einer ausgewählten Fehlerkorrekturfähigkeit ist, die die Daten gegen den schlimmstmöglich angenommenen Fall von auftretenden Fehlern in Daten, die auf dem Medium aufgezeichnet werden, schützt, wobei die Vorrichtung weiterhin durch einen Nulladdierer (20) gekennzeichnet ist, der auf vom Medium gelesene Wörter reagiert, um die Wörter mit einer Zahl von addierten Nullbytes zu erhöhen, die ausreicht, um einen Ausgleich für die Anzahl der vom aufgezeichneten Datenwort unterdrückten redundanten Bytes zu schaffen, sowie einen Syndromgenerator (21), (22), (24), der von

einem derart erhöhten Wort ein Fehlersyndrompolynom (I) erzeugt, das sich auf den Bereich, aus dem das Wort gelesen wird, bezieht, sowie einen Decoder (25), der Daten, welche in Übereinstimmung mit dem Reed-Solomon-Code codiert wurden, decodiert und die addierten Nullbytes als Löschungen behandelt.

**10.** Eine Vorrichtung nach Anspruch 8 oder 9 mit einem Fehlerzähler, der das Auftreten von Fehlern in vom Medium gelesenen Daten überwacht, und die weiterhin dadurch gekennzeichnet ist, daß ein Rückkopplungsmittel zur Kontrolle der Anzahl von unterdrückten redundanten Bytes in Übereinstimmung mit der Einstellung des Fehlerzählers vorhanden ist.

## Revendications

**1.** Procédé de correction des erreurs, pour utilisation avec un milieu de stockage sur disque, dont les statistiques d'erreur fluctuent en fonction de l'emplacement auquel les données sont enregistrées, comprenant les étapes d'encodage des données suivant un code de correction d'erreurs, susceptible de corriger un nombre donné d'erreurs pour développer des mots comprenant des multiplets de données et des multiplets redondants et la division dudit disque de stockage en bandes d'enregistrement concentriques dont les données sont codées différemment, le procédé étant caractérisé en ce que différentes statistiques d'erreurs sont appliquées, à différentes bandes d'enregistrement, en ce qu'un ou plusieurs desdits multiplets redondants sont supprimés des données codées, suivant la bande d'enregistrement à laquelle on veut accéder, de manière à ajuster le nombre d'erreurs pouvant être corrigées suivant les besoins d'aptitude à la correction d'erreurs dans chaque aire d'enregistrement, et en ce que le nombre de multiplets redondants supprimés est déterminé par le rayon de la bande à laquelle est effectué l'accès.

**2.** Procédé selon la revendication 1, dans lequel les données sont enregistrées dans chaque bande à une fréquence d'horloge allant en augmentant avec le rayon intérieur de la bande, et dans lequel le nombre de multiplets redondants supprimés va en diminuant progressivement, lorsque les bandes sont d'un rayon allant en augmentant.

**3.** Procédé selon la revendication 1, dans lequel des données sont enregistrées à une fréquence fixe et le nombre de multiplets redondants supprimés est diminué progressivement pour les bandes dont le rayon va en diminuant.

**4.** Procédé selon l'une quelconque des revendications précédentes dans lequel ledit code de correction d'erreurs est un code Reed-Solomon ayant une capacité de correction d'erreurs sélectionnée pour protéger les données contre l'incidence anticipée d'occurrence du pire des cas concernant les erreurs de données enregistrées sur ledit milieu.

**5.** Procédé selon la revendication 4, comprenant en outre l'étape, lorsqu'est effectuée la lecture de données à partir dudit milieu, d'augmentation de chaque mot lu par un nombre de multiplets de zéro suffisant pour compenser les multiplets redondants supprimés au moment de l'enregistrement et traitement de chaque multiplet de zéro à titre d'effacement dans le but de décodage.

**6.** Procédé selon l'une quelconque des revendications précédentes, pour utilisation avec un milieu de mémorisation dont les statistiques d'erreur varient en fonction du temps, comprenant l'étape de détermination des statistiques d'erreurs dudit milieu, à des moments déterminés et modification du nombre de multiplets redondants supprimés en fonction de toute fluctuation de ces statistiques.

**7.** Procédé selon la revendication 6, dans lequel lesdites statistiques d'erreur sont déterminées par surveillance de l'incidence des erreurs dans les données lues à partir dudit milieu.

**8.** Dispositif de mémorisation de données comprenant un milieu de stockage sur disque, divisé en bandes d'enregistrement concentriques, dont les données sont codées différemment, un encodeur (10) adapté pour encoder des données destinées à l'enregistrement, en fonction d'un code de correction d'erreurs en mesure de corriger un nombre donné d'erreurs, pour développer des mots comprenant des multiplets de données et des multiplets redondants, caractérisé en ce qu'il est adapté pour traiter des statistiques d'erreurs différentes sur des bandes d'enregistrement différentes et en ce qu'il comprend en outre un identificateur de zone (12), adapté pour produire un signal de sortie identifiant la bande d'enregistrement dans laquelle les données doivent être enregistrées et un effaceur (11), réagissant au signal de sortie dudit identificateur de zone, en vue de supprimer des multiplets redondants donnés parmi lesdits multiplets redondants.

**9.** Dispositif selon la revendication 8, dans lequel ledit code de correction d'erreurs est un code Reed-Solomon ayant

une capacité de correction d'erreurs sélectionnée pour protéger les données contre une incidence anticipée du pire cas ou d'erreurs rencontrées dans les données enregistrées dans ledit milieu, caractérisé en outre par un additionneur de zéro (20), réagissant à des mots lus à partir dudit milieu, pour augmenter ces mots d'un nombre donné de multiplets de zéro ajoutés, suffisant pour effectuer la compensation du nombre de multiplets redondants supprimés du mot de données enregistré, un générateur de syndrome (21), (22), (24) susceptible de fonctionner pour développer à partir d'un mot ainsi augmenté une fonction polynomiale de syndrome d'erreurs (I), appropriée à la zone d'où le mot a été lu, et un décodeur (25) adapté pour décoder les données encodées suivant ledit code Reed-Solomon et pour traiter les multiplets zéro ajoutés à titre de signaux d'effacement.

**10.** Dispositif selon la revendication 8 ou 9, comprenant un compteur d'erreurs, agencé pour surveiller l'incidence des erreurs dans les données lues à partir dudit milieu, caractérisé en outre par des moyens de réaction agencés pour contrôler le nombre de multiplets redondants supprimés suivant l'état de comptage dudit compteur d'erreurs.

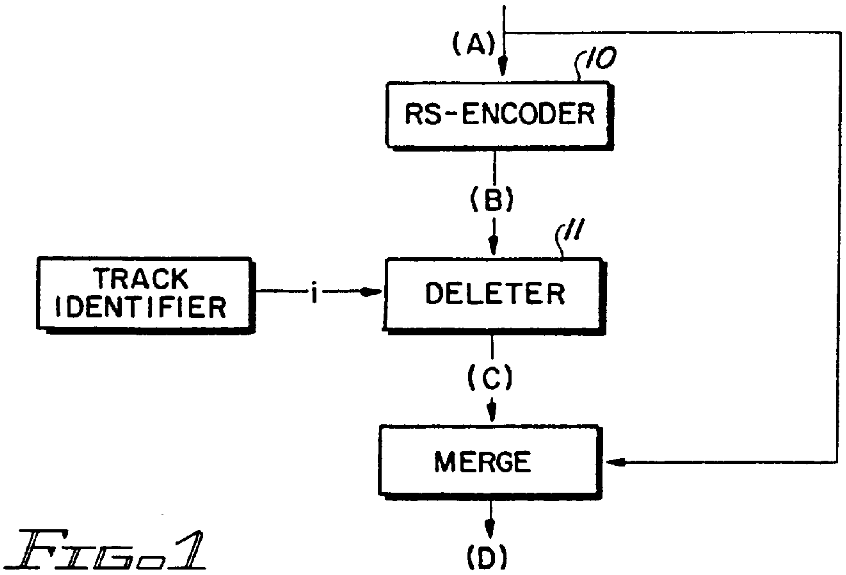
(A)
10
RS-ENCODER
(B)
11
TRACK IDENTIFIER
i
DELETER
(C)
MERGE
(D)

FIG. 1

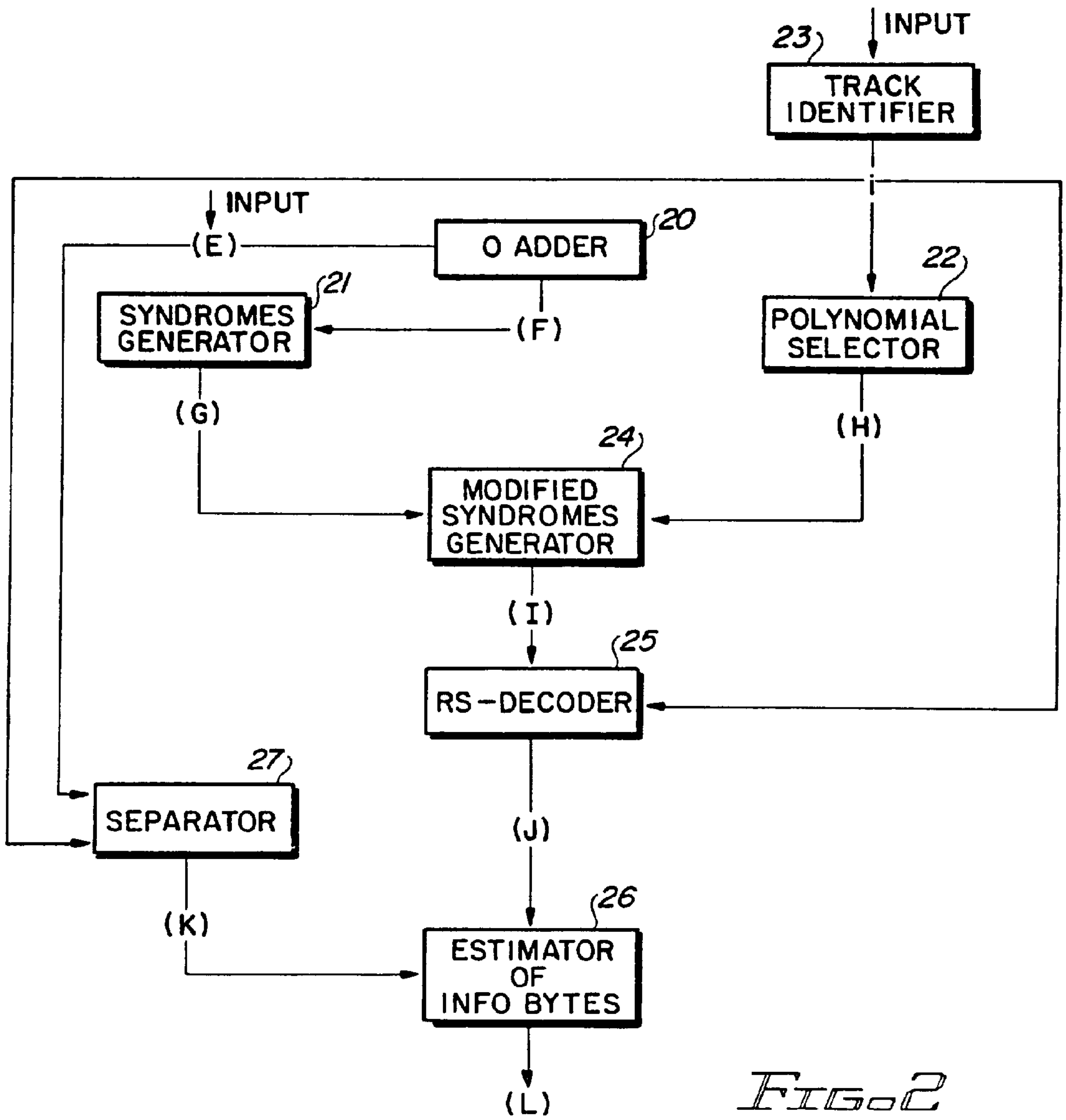
INPUT
23
TRACK IDENTIFIER
INPUT
(E)
O ADDER
20
21
SYNDROMES GENERATOR
(F)
22
POLYNOMIAL SELECTOR
(G)
(H)
24
MODIFIED SYNDROMES GENERATOR
(I)
25
RS-DECODER
27
SEPARATOR
(J)
(K)
26
ESTIMATOR OF INFO BYTES
(L)

FIG. 2